Europäisches Patentamt

European Patent Office

Office européen des brevets

(19)

(11) **EP 0 715 313 B1**

(12) **EUROPÄISCHE PATENTSCHRIFT**

(45) Veröffentlichungstag und Bekanntmachung des Hinweises auf die Patenterteilung:
**18.04.2001   Patentblatt 2001/16**

(51) Int Cl.⁷: **G11C 16/06**

(21) Anmeldenummer: **95117669.2**

(22) Anmeldetag: **09.11.1995**

(54) **Verfahren zur Programmierung eines elektrisch löschbaren, nichtflüchtigen Speichers in einem elektronischen Rechengerät sowie Steuergerät zur Verwendung bei dem Verfahren**

Method of programming an electrically erasable read-only memory in an elecronic computer device and control device using the method

Procédé pour la programmation d'une mémoire morte électriquement effaçable dans un appareil de calcul électronique et appareil de commande pour la mise en oeuvre de ce procédé

(84) Benannte Vertragsstaaten:
**DE FR GB IT SE**

(30) Priorität: **03.12.1994  DE 4443065**

(43) Veröffentlichungstag der Anmeldung:
**05.06.1996   Patentblatt 1996/23**

(73) Patentinhaber: **ROBERT BOSCH GMBH**
**70442 Stuttgart (DE)**

(72) Erfinder:
• **Bauer, Juergen**
**D-71229 Leonberg (DE)**
• **Seher, Dieter, Dr. Ing.**
**D-74360 Ilsfeld (DE)**
• **Rueping, Thomas, Dipl.-Ing. (FH)**
**D-73252 Lenningen (DE)**
• **Baehren, Thomas, Dipl.-Ing.**
**D-71636 Ludwigsburg (DE)**
• **Jahn, Thilo, Dipl.-Ing.**
**D-71638 Ludwigsburg (DE)**

(56) Entgegenhaltungen:
**EP-A- 0 477 503        EP-A- 0 542 156**
**EP-A- 0 548 681        US-A- 5 297 148**
**US-A- 5 359 569**

**Beschreibung**

Stand der Technik

Die Erfindung geht aus von einem Verfahren zur Programmierung eines elektrisch löschbaren, nichtflüchtigen Speichers nach der Gattung des Hauptanspruchs. Es ist schon ein Verfahren zur Programmierung eines elektrisch löschbaren, nichtflüchtigen Speichers aus dem Zeitschriftenartikel "Flash-EPROMs" von Thomas Scherer, Elektor 4/92, Seiten 16 bis 20 bekannt. In dem genannten Zeitschriftenartikel werden die in letzter Zeit zunehmend Verwendung findenden Flash-EPROMs beschrieben. Es wird hervorgehoben, daß die Flash-EPROMs elektrisch löschbare Speicher sind. Weiterhin wird darin hervorgehoben, daß Flash-EPROMs in der Anwendungsschaltung, in die sie eingesetzt sind, programmiert werden können und für die Programmierung nicht extra in ein externes Programmiergerät eingesteckt werden müssen. Es wird weiterhin darauf hingewiesen, daß Flash-EPROMs mit verschiedenen, getrennt voneinander löschbaren Zonen zur Verfügung stehen.

Flash-EPROMs werden in zunehmendem Maße auch in Kraftfahrzeug-Steuergeräten eingesetzt. Sehr häufig werden dabei die Blocked Flash-EPROMs eingesetzt, die die verschiedenen getrennt voneinander löschbaren Zonen aufweisen. Beim Einsatz dieser Speicherbausteine ergibt sich das Problem, daß aufgrund der lediglich blockweisen Löschbarkeit die Programmierung einzelner Speicherworte in einem Speicherblock erschwert ist. Bei den Kraftfahrzeug-Steuergeräten ist es aber üblich, daß z.B. bestimmte im Speicher abgelegte Kennlinien nachträglich nach Fertigstellung des Kraftfahrzeuges individuell abgeglichen werden müssen, wozu eine speicherwortweise Programmierung des elektrisch löschbaren, nichtflüchtigen Speichers nötig ist. Flash-Speicher sind auch aus der US 5 297 148 bekannt.

Vorteile der Erfindung

Das erfindungsgemäße Verfahren mit den kennzeichnenden Merkmalen des Hauptanspruchs hat demgegenüber den Vorteil, daß auf einfache Art und Weise eine speicherwortweise Programmierung eines elektrisch löschbaren, nichtflüchtigen Speichers, der jedoch nur blockweise löschbar ist, möglich ist. Somit bleibt es für die Kraftfahrzeughersteller und die Werkstattbediensteten des Kraftfahrzeugherstellers möglich, die Steuergeräte, in denen Flash-EPROMs als Speicherbausteine eingesetzt sind, wie gewohnt zu programmieren.

Durch die in den Unteransprüchen aufgeführten Maßnahmen sind vorteilhafte Weiterbildungen und Verbesserungen des im Hauptanspruch angegebenen Verfahrens möglich. Durch die Maßnahmen gemäß Anspruch 2 kann das elektronische Rechengerät nach erfolgter Programmierung des elektrisch löschbaren, nichtflüchtigen Speichers jederzeit den neu programmierten Speicherblock auf einfache Art und Weise überprüfen und so eventuelle z.B. durch Alterung bedingte, aufgetretene Fehler feststellen.

Besonders vorteilhaft ist darüberhinaus, daß der Sicherungsspeicherblock und der Notizblockspeicherblock jeweils in dem zu programmierenden elektrisch löschbaren, nichtflüchtigen Speicher enthalten ist. Dadurch wird die größtmögliche Sicherheit bei der Programmierung des elektrisch löschbaren, nichtflüchtigen Speichers erreicht. Selbst dann, wenn während der Programmierung die Versorgungsspannung ausfällt oder eine Verbindung zwischen einem externen Programmiergerät und dem zu programmierenden elektronischen Rechengerät unterbrochen wird, sind in dem Sicherungsspeicherblock und dem Notizblockspeicherblock alle notwendigen Informationen gespeichert, so daß der Programmiervorgang wiederholt werden kann und kein Datenverlust entsteht.

Ebenfalls vorteilhaft ist, wenn der Sicherungsspeicherblock und/oder der Notizblockspeicherblock in einem flüchtigen Speicher des zu programmierenden elektronischen Rechengeräts positioniert ist. In diesem Fall ist zwar keine absolute Sicherheit gegen ungewollte Programmunterbrechungen vorhanden, es kann aber auf diese Art und Weise ein oder zwei Speicherblöcke des elektrisch löschbaren, nichtflüchtigen Speichers eingespart werden, so daß die Herstellungskosten des elektronischen Rechengeräts reduziert sind.

Die zu programmierenden Daten können vorteilhafterweise von einem externen Programmiergerät zu dem elektronischen Rechengerät über eine serielle Datenübertragungsleitung übertragen werden.

Für ein Steuergerät zur Verwendung bei dem erfindungsgemäßen Verfahren ist es vorteilhaft, wenn ein Sicherungsspeicherblock und ein Notizblockspeicherblock vorgesehen ist. Dadurch ist nämlich die größtmögliche Sicherheit bei der Programmierung gegeben. Wenn die Versorgungsspannung ausfällt oder eine Verbindung zwischen externem Programmiergerät und Steuergerät während der Programmierung unterbrochen wird, sind in dem Sicherungsspeicherblock und dem Notizblockspeicherblock alle notwendigen Informationen gespeichert, so daß der Programmiervorgang wiederholt werden kann und kein Datenverlust entsteht. Weitere vorteilhafte Ausbildungen des Steuergeräts sind in den Unteransprüchen 7 bis 9 angegeben.

Zeichnung

Ein Ausführungsbeispiel der Erfindung ist in der Zeichnung dargestellt und in der nachfolgenden Beschreibung näher erläutert. Es zeigen:

Figur 1 ein grobes Blockschaltbild der Anordnung zur Programmierung des elektrisch löschbaren, nichtflüchtigen Speichers;

Figur 2 ein Ablaufdiagramm für die Programmierung des elektrisch löschbaren, nichtflüchtigen Speichers;

Figur 3 eine schematische Darstellung der Speicheraufteilung des elektrisch löschbaren, nichtflüchtigen Speichers zu verschiedenen Zeitpunkten während des Programmiervorgangs

und Figur 4 ein Beispiel für die Berechnung einer Prüfsumme für einen bestimmten Speicherbereich.

Beschreibung der Erfindung

Die Erfindung soll vorwiegend auf dem Gebiet von Kraftfahrzeug-Steuergeräten eingesetzt werden. Derartige Kraftfahrzeug-Steuergeräte sind z.B. Motor-Steuergeräte, Getriebe-Steuergeräte, Brems-Steuergeräte, usw. In derartigen Steuergeräten sind Mikrorechner enthalten, die bestimmte Steuerprogramme abarbeiten. Die Steuerprogramme greifen vielfach auf bestimmte Daten, z.B. Kennnlinien, Kennfelder, Kenngrößen usw. zu. Einige dieser Kennlinien werden erst nachdem das Steuergerät fertiggestellt wurde am Ort ihres Einsatzes abgeglichen. Als Beispiel wird hierfür die Drehmoment-Kennlinie eines Motor-Steuergerätes genannt. Erst nachdem das Motor-Steuergerät am Bandende der Produktion des Kraftfahrzeuges in das Kraftfahrzeug eingesetzt wurde, wird die Drehmoment-Kennlinie abgeglichen. Zu diesem Zeitpunkt ist auch der Motor des Kraftfahrzeuges schon eingebaut. Es findet dann ein Testlauf statt, bei dem das abgegebene Motormoment bei verschiedenen Drehzahlen gemessen wird und dementsprechend die Motormoment-Kennlinie abgeglichen wird. Das abgegebene Motormoment kann nämlich bei den gleichen Betriebsbedingungen von Motor zu Motor etwas streuen, so daß der beschriebene Abgleich erforderlich ist. Bei herkömmlichen Motor-Steuergeräten war die Kennlinie für das Motormoment in einem wortweise organisierten elektrisch löschbaren, nichtflüchtigen Speicher (EEPROM) abgespeichert. Dieser konnte wortweise gelöscht und programmiert werden, so daß der Abgleich der Motormoment-Kennlinie unproblematisch stattfinden konnte.

Weitere Beispiele für Speichereinträge in den elektrisch löschbaren, nichtflüchtigen Speicher, die auch nachträglich noch verändert werden müssen, sind z.B. die Fehlerspeichereinträge eines Kraftfahrzeug-Steuergerätes. Da die Fehler erst während des Betriebes des Kraftfahrzeuges auftreten können, war hierzu bei herkömmlichen Kraftfahrzeug-Steuergeräten auch der elektrisch löschbare, nichtflüchtige Speicher vorgesehen. Da die Programmierung der speicherwortweise organisierten elektrisch löschbaren, nichtflüchtigen Speicher kein Problem darstellte, war es ohne Probleme möglich, Fehlereinträge in den elektrisch löschbaren, nichtflüchtigen Speicher einzutragen und auch wieder speicherwortweise zu löschen, falls der Fehler nur sporadisch auftrat. Zukünftig soll der speicherwortweise elektrisch löschbare, nichtflüchtige Speicher durch die blockweise organisierten elektrisch löschbaren, nichtflüchtigen Speicher ersetzt werden. Die Programmierung von einzelnen Speicherworten ist dann aber erschwert. Hierzu bietet die Erfindung eine Lösung.

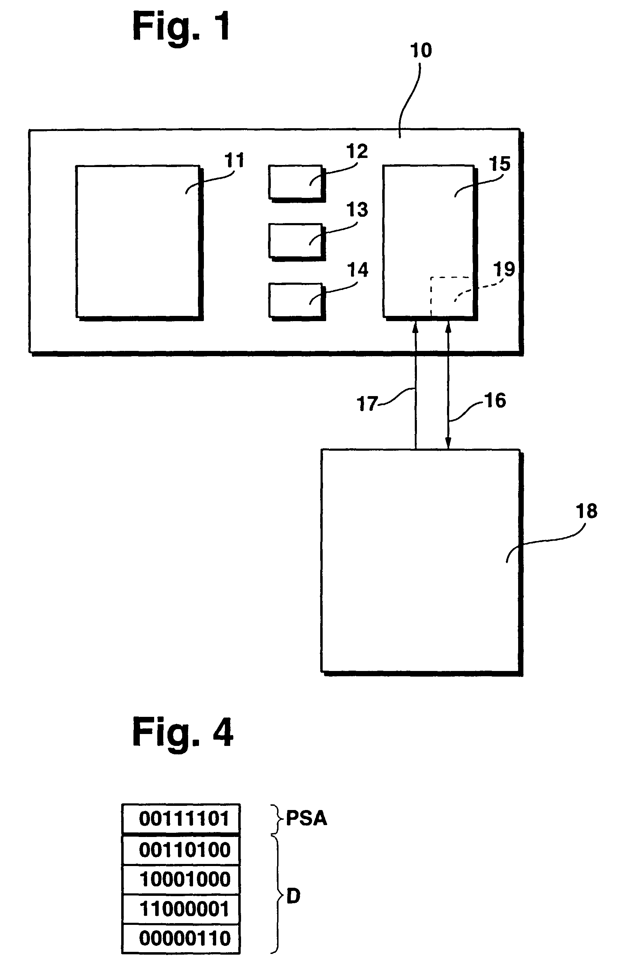

In der Figur 1 bezeichnet die Bezugszahl 10 ein Kraftfahrzeug-Steuergerät. Dieses enthält eine Zentraleinheit 11, einen elektrisch löschbaren, nichtflüchtigen Speicher 12, einen flüchtigen Speicher 13 einen Nur-Lese-Speicher 14 sowie diverse Ein-/Ausgabeschaltkreise 15. Durch gestrichelte Linierung hervorgehoben ist eine serielle Schnittstelle 19. Der elektrisch löschbare, nichtflüchtige Speicher 12 ist vorteilhafterweise als Flash-EPROM ausgebildet. Diese Speicherart erlaubt nämlich sowohl eine hohe Speicherdichte, Nichtflüchtigkeit, als auch die Möglichkeit der elektrischen Löschung des Speicherinhaltes. Der Nur-Lese-Speicher 14 ist als ROM bekannt. Das Kraftfahrzeug-Steuergerät 10 ist über eine serielle Datenübertragungsleitung 16 mit einem externen Programmiergerät 18 verbunden. Über die separate Leitung 17 wird die Programmierspannung für die Programmierung des elektrisch löschbaren, nichtflüchtigen Speicher 12 zu dem Steuergerät 10 eingespeist.

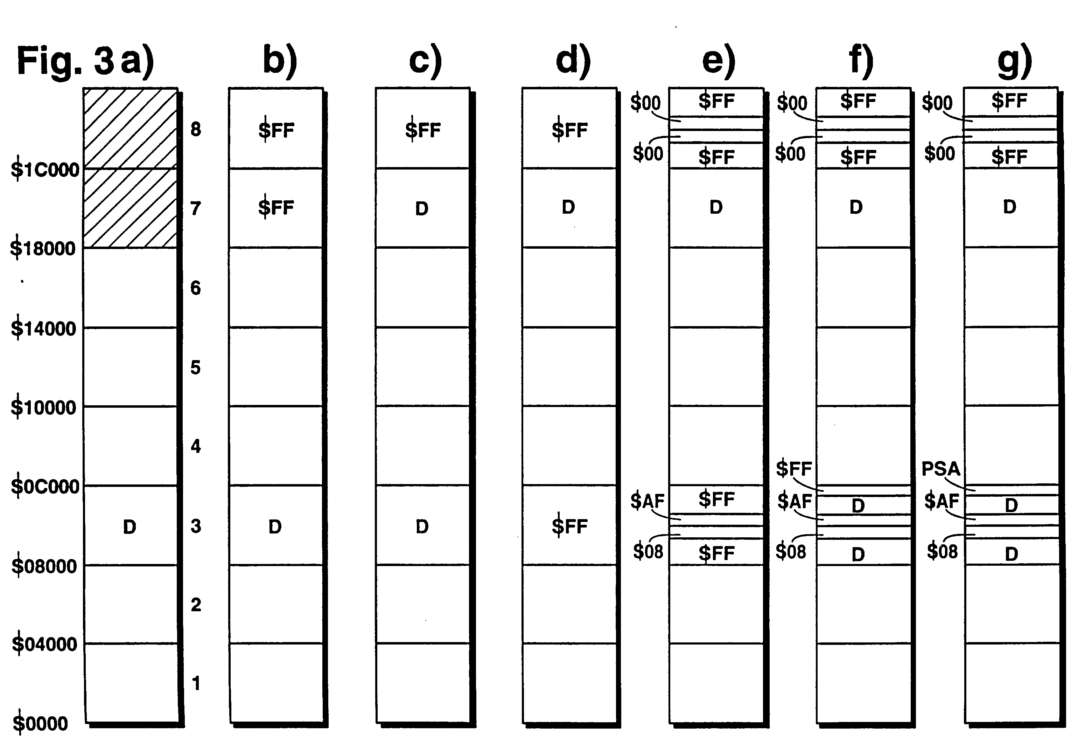

Als Beispiel für einen elektrisch löschbaren, nichtflüchtigen Speicher 12 wird ein heute kommerziell erhältlicher Ein-Megabit-Flash-EPROM-Baustein genannt. Die Speicheraufteilung ist in Figur 3a dargestellt. Der gesamte Speicher ist in acht 16 kByte große Speicherblöcke aufgeteilt. Der Speicherblock 1 enthält die Adressen $00000 bis $03FFF. Speicherblock 2 enthält die Adressen $04000 bis $07FFF. Speicherblock 3 enthält die Adressen $08000 bis $0BFFF. Speicherblock 4 enthält die Adressen $0C000 bis $0FFFF. Speicherblock 5 enthält die Adressen $10000 bis $13FFF. Speicherblock 6 enthält die Adressen $14000 bis $17FFF. Speicherblock 7 enthält die Adressen $18000 bis $1BFFF. Speicherblock 8 enthält die Adressen $1C000 bis $1FFFF. Insgesamt bietet also dieser Baustein Platz für 128 kByte Daten.

In dem Speicherblock 3 sind die Daten der Kennlinien und Kennfelder des Steuerprogramms abgelegt. Nachfolgend wird der Speicherblock 3 als Datenspeicherblock bezeichnet.

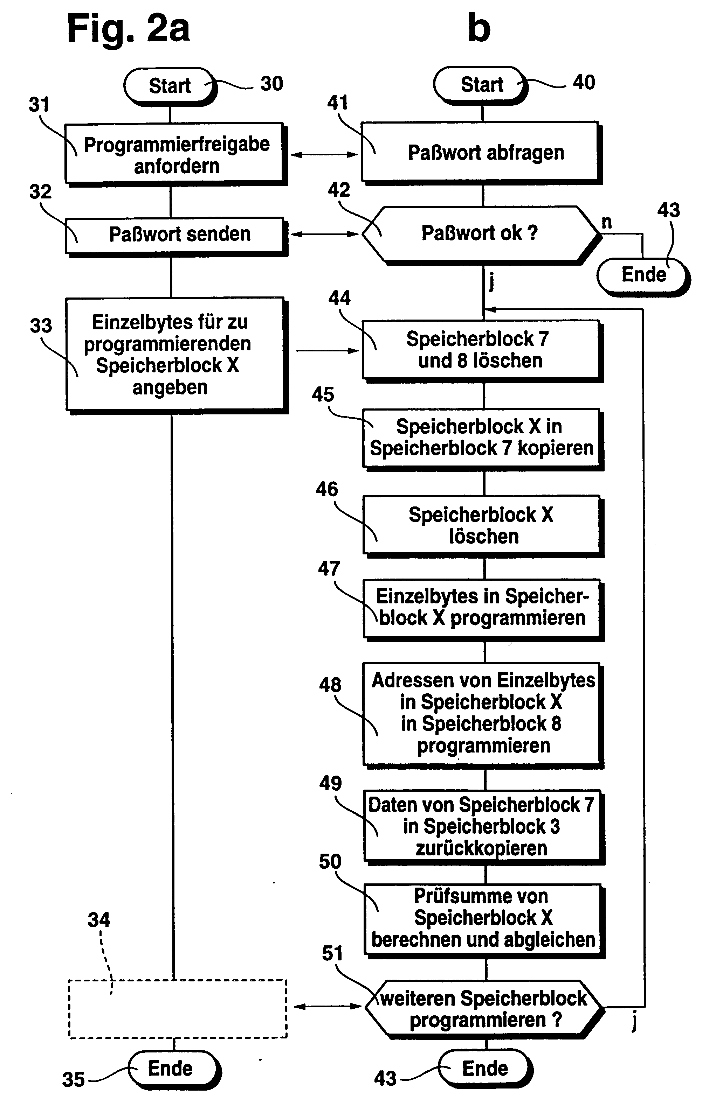

Anhand der Figur 2 und der Figur 3 wird nachfolgend erläutert, wie ein Speicherwort des Datenspeicherblocks 3 zum Abgleich z.B. der Drehmomentkennlinie erfindungsgemäß umprogrammiert wird. Figur 2a stellt das Ablaufdiagramm von Seiten des externen Programmiergerätes 18 dar. Figur 2b stellt das Ablaufdiagramm von Seiten des elektronischen Rechengerätes 10 dar. Mit der Bezugszahl 30 ist der Programmstart für das externe Programmiergerät 18 bezeichnet. Im Programmschritt 31 sendet das externe Programmiergerät 18 die Aufforderung zur Programmierfreigabe zu dem Kraftfahrzeug-Steuergerät 10. Nach dem Programmstart 40 erkennt das Kraftfahrzeug-Steuergerät 10, daß es zu einer Programmierfreigabe aufgefordert wurde. Im Programmschritt 41 fordert es dann ein Paßwort für die Programmierfreigabe von dem externen Programmiergerät 10 an. Im Programmschritt 32 sendet das externe Programmiergerät 18 das nötige Paßwort. Das empfangene Paßwort wird von dem Kraftfahrzeug-Steuergerät im Programmschritt 42 überprüft. Falls das Paßwort fehlerhaft oder falsch übertragen wurde, beendet das Kraftfahrzeug-Steuergerät 10 im Programmschritt 43 die Programmierung. Wurde das Paßwort im Programmschritt 42 als korrekt erkannt, gibt das Kraftfahrzeug-Steuergerät 10 eine Meldung an das externe Programmiergerät aus, mit der es seine Programmierbereitschaft anzeigt. Im Programmschritt 33 sendet dann das externe Programmiergerät 18 die einzelnen Speicherwörter für einen zu programmierenden Speicherblock X. Das Kraftfahrzeug-Steuergerät 10 übernimmt die übertragenen Daten und startet im Programmschritt 44 den Programmieralgorithmus zur Abspeicherung der empfangenen Daten. Gemäß Figur 3a ist der zu programmierende Speicherblock X der Datenspeicherblock 3. Im Programmschritt 44 wird als erster Schritt zur Programmierung des elektrisch löschbaren, nichtflüchtigen Speichers der Speicherblock 7 und der Speicherblock 8 gelöscht. Dieser Schritt ist auch in Figur 3b dargestellt. Nach dem Löschvorgang sind in den Speicherblöcken 7 und 8 alle Speicherworte mit dem Eintrag $FF belegt. Dies ist in Figur 3b auch dargestellt.

Im Programmschritt 45 wird der ausgewählte Speicherblock X in den jetzt noch unprogrammierten Speicherblock 7 kopiert. Dieser Schritt ist in Figur 3c dargestellt. Es ist anhand der Figur 3c erkennbar, daß in den Speicherblock 7 nach diesem Programmschritt die Daten D enthalten sind, die auch im Datenspeicherblock 3 abgespeichert sind.

Der nächste Programmschritt 46 betrifft die Löschung des ausgewählten Speicherblocks X. Dies ist in Figur 3d dargestellt. Es ist erkennbar, daß nach diesem Programmschritt im Datenspeicherblock 3 alle Speicherworte mit $FF belegt sind. Im nachfolgenden Programmschritt 47 werden die zuvor übertragenen Einzelbytes in den Speicherblock X programmiert. Im nachfolgenden Programmschritt 48 werden die Adressen der Einzelbytes, die in den Speicherblock X im Programmschritt 47 einprogrammiert wurden, in den Speicherblock 8 eingetragen. In Figur 3e sind beide Programmschritte dargestellt. Es ist erkennbar, daß auf einer ausgewählten Adresse der Eintrag $08 erfolgt ist und auf der darauf folgenden Adresse der Eintrag $AF erfolgt ist. An allen anderen Adressen des Datenspeicherblocks 3 sind noch die Einträge $FF vorhanden. In den Speicherblock 8 wurde auf Adresse $1E500 und Adresse $1E501 der Wert $00 eingetragen. In Speicherblock 8 wird damit ein Merkdatenwort jeweils an der Adresse eingetragen, die der Adresse von Speicherblock 3 entspricht, an der eine Einzelbyteprogrammierung erfolgte. Die Adresse in Speicherblock 8 berechnet sich nach der Formel:

$$Adr8 = Off8 + (Adr3 - Off3).$$

Dabei ist    Adr8 die Adresse von Speicherblock 8, in der das Merkdatenwort $00 eingetragen wird; Off8 die Adresse des Anfangs (Offset) von Speicherblock 8, im Ausführungsbeispiel $1C000; Off 3 die Adresse des Anfangs (Offset) von Speicherblock 3, im Ausführungsbeispiel $08000, Adr3 die Adresse von Speicherblock 3, in der eine Einzelbyteprogrammierung erfolgte.

Der Speicherblock 8 wird im Sinne dieser Anmeldung als Notizblockspeicherblock bezeichnet.

Im Programmschritt 49 werden die Daten von Speicherblock 7 unter Berücksichtigung der Einträge in Speicherblock 8 in den Datenspeicherblock 3 zurückkopiert. Dabei werden nur diejenigen Daten in den Datenspeicherblock 3 zurückkopiert, die nicht unter Adressen abgespeichert sind, die denen entsprechen, die in dem Notizblockspeicherblock 8 als neu programmiert markiert sind. Es ist dabei zu erwähnen, daß die letzte Speicherstelle des Sicherungsspeicherblocks 7 ebenfalls nicht mit in den Datenspeicherblock 3 zurückkopiert wird. Diese Speicherstelle dient nämlich für einen Prüfsummenabgleich, der nachfolgend noch anhand der Figur 4 näher erläutert wird.

Anhand der Figur 3f ist erkennbar, daß in den Datenspeicherblock 3 bis auf die letzte Speicherstelle die Daten aus dem Sicherungsspeicherblock 7 übernommen wurden, wobei die Einträge, die in einem Schritt vorher unter den Adressen $0A500 und $0A501 vorgenommen wurden erhalten sind.

Im Programmschritt 50 wird eine Prüfsumme zu dem Datenspeicherblock 3 berechnet. Dazu werden sämtliche Speichereinträge in diesem Speicherblock addiert. Von dem Ergebnis wird die hexadezimale Zahl $100 abgezogen. Die sich so ergebende Zahl wird als Prüfsummenabgleich PSA in der letzten Adresse des Datenspeicherblocks 3 einprogrammiert. Dieser Vorgang ist auch anhand der Figur 3g erkennbar. Darin wird deutlich, daß in der letzten Adresse des Datenspeicherblocks 3 der Eintrag PSA vorhanden ist.

Nach dem Programmschritt 50 sendet das Kraftfahrzeug-Steuergerät 10 eine Meldung an das externe Programmiergerät 18, mit der es dem externen Programmiergerät 18 mitteilt, daß es die Programmierung des Speicherblocks 3 durchgeführt hat. Das externe Programmiergerät 18 kann dann die Programmierung weiterer Speicherblöcke anfordern. Dies ist mit dem gestrichelten Programmschritt 34 angedeutet. In Abfrage 51 erkennt dann das Kraftfahrzeug-Steuergerät 10, daß es noch weitere Speicherblöcke programmieren soll und führt dann die Programmschritte 44 bis 50 entsprechend aus. Wurde in Abfrage 51 erkannt, daß keine weiteren Speicherblöcke programmiert werden sollen, wird die Programmierung im Programmschritt 43 beendet. Nach dem Programmschritt 34 wird auch das Programm des externen Programmiergeräts 18 im Programmschritt 35 beendet.

In Figur 4 ist ein einfacher Speicherblock mit lediglich fünf Speicheradressen dargestellt. Mit der Bezugszahl D ist der Datenteil dieses Speicherblocks bezeichnet. Die Binärzahlen, die unter den Speicheradressen in dem Datenteil D des Speicherblocks abgelegt sind, sind ebenfalls dort angegeben. Die Prüfsumme für den Datenteil D berechnet sich einfach aus der Binäraddition aller Binärzahlen in dem Datenteil D. Von dem sich dann ergebenden Ergebnis wird die hexadezimale Zahl $100 abgezogen. Es ergibt sich die Zahl, die unter der obersten Adresse des dargestellten Speicherblocks eingetragen ist. Die Zahl entspricht dem Prüfsummenabgleich PSA. Wenn nun nachfolgend der Mikrorechner des Kraftfahrzeug-Steuergerätes die Prüfsumme über den gesamten dargestellten Speicherblock berechnet, ergibt sich automatisch das Ergebnis 0. Daran ist immer einfach erkennbar, ob alle Speicherzellen des Speicherblocks noch richtig gesetzt sind oder nicht.

**Patentansprüche**

1. Verfahren zur Programmierung eines elektrisch löschbaren, nichtflüchtigen Speichers in einem elektronischen Rechengerät, insbesondere Kraftfahrzeug-Steuergerät, wobei der elektrisch löschbare, nichtflüchtige Speicher in eine Anzahl Speicherblöcke eingeteilt ist und die Löschung des elektrisch löschbaren, nichtflüchtigen Speichers nur blockweise möglich ist, dadurch gekennzeichnet, daß für die Programmierung mindestens zwei Speicherblöcke (7, 8) außer einem Datenspeicherblock (3), in den zumindest teilweise neue Daten einprogrammiert werden sollen, vorgesehen werden, wobei der eine Speicherblock als Sicherungsspeicherblock (7) verwendet wird und der andere Speicherblock als Notizblockspeicherblock (8) verwendet wird, daß in einem ersten Schritt der Notizblockspeicherblock (8) und der Sicherungsspeicherblock (7) gelöscht wird, daß in einem zweiten Schritt der Inhalt des Datenspeicherblocks (3) in den Sicherungsspeicherblock (7) kopiert wird, daß in einem dritten Schritt der Datenspeicherblock (3) gelöscht wird, daß in einem vierten Schritt in den Datenspeicherblock (3) die neuen Daten einprogrammiert werden, daß in einem fünften Schritt in den Notizblockspeicherblock (8) einprogrammiert wird, unter welchen Adressen die neuen Daten in den Datenspeicherblock (3) einprogrammiert wurden, und daß in einem sechsten Schritt die Daten aus dem Sicherungsspeicherblock (7) in den Datenspeicherblock (3) zurückkopiert werden, wobei nur diejenigen Adressen, des Datenspeicherblocks (3) mit den entsprechenden Daten aus dem Sicherungsspeicherblock (7) überschrieben werden, die nicht entsprechend der Einträge in dem Notizblockspeicherblock (8) als mit neuen Daten belegt erkannt werden.

2. Verfahren nach Anspruch 1, dadurch gekennzeichnet, daß als siebter Schritt eine Prüfsumme für den Datenspeicherblock (3) berechnet wird und daß ausgehend von dem Ergebnis der Prüfsumme in eine zu diesem Zweck freigelassene Speicherstelle des Datenspeicherblocks (3) ein Datenwort (PSA) einprogrammiert wird, das die berechnete Prüfsumme zu einem vorbestimmten Prüfsummenergebnis, insbesondere 0, ergänzt.

3. Verfahren nach Anspruch 1 oder 2, dadurch gekennzeichnet, daß als Sicherungsspeicherblock (7) und als Notizblockspeicherblock (8) jeweils ein Speicherblock im elektrisch löschbaren, nichtflüchtigen Speicher (12) verwendet wird.

4. Verfahren nach Anspruch 1 oder 2, dadurch gekennzeichnet, daß als Sicherungsspeicherblock (7) und/oder als Notizblockspeicherblock (8) jeweils ein Speicherblock in einem flüchtigen Speicher (13) des elektronischen Rechengerätes (10) verwendet wird.

5. Verfahren nach einem der vorhergehenden Ansprüche, dadurch gekennzeichnet, daß die neuen Daten von einem externen Programmiergerät (18) zu dem elektronischen Rechengerät (10) über eine serielle Datenübertragungsleitung (16) übertragen werden.

6. Steuergerät zur Durchführung des Verfahrens nach Anspruch 1, insbesondere KFZ-Steuergerät, mit einem Mikrorechner, mit einem elektrisch löschbaren, nichtflüchtigen Speicher, der in eine Anzahl Speicherblöcke eingeteilt ist und blockweise löschbar ist, mit einer seriellen Schnittstelle zur Kommunikation mit einem externen elektronischen Gerät, mit Mitteln zur Programmierung des elektrisch löschbaren, nichtflüchtigen Speichers, dadurch gekennzeichnet, daß als Mittel zur Programmierung des elektrisch löschbaren, nichtflüchtigen Speichers (12) ein Sicherungsspeicherblock (7) vorgesehen ist, in den die Daten eines zu programmierenden Datenspeicherblocks (3) einschreibbar sind, und daß zusätzlich ein Notizblockspeicherblock (8) vorgesehen ist, in den Informationen, insbesondere Merkdatenwörter, einschreibbar sind, die angeben, unter welchen Adressen des zu programmierenden Datenspeicherblocks (3) eine Neuprogrammierung stattfinden soll bzw. stattgefunden hat.

7. Steuergerät nach Anspruch 6, dadurch gekennzeichnet, daß der Sicherungsspeicherblock (7) und/oder Notizblockspeicherblock (8) Teil des elektrisch löschbaren, nichtflüchtigen Speichers (12) ist.

8. Steuergerät nach Anspruch 6, dadurch gekennzeichnet, daß der Sicherungsspeicherblock (7) und/oder Notizblockspeicherblock (8) Teil eines flüchtigen Speichers (13) ist.

9. Steuergerät nach einem der Ansprüche 6 bis 8, dadurch gekennzeichnet, daß der elektrisch löschbare, nichtflüchtige Speicher (12) ein Flash-EPROM ist.

## Claims

1. Method for programming an electrically erasable, non-volatile memory in an electronic computing unit, in particular motor vehicle control unit, the electrically erasable, non-volatile memory being divided into a number of memory blocks and it being possible to erase the electrically erasable, non-volatile memory only in blocks, characterized in that there are provided for the programming at least two memory blocks (7, 8) in addition to a data memory block (3), into which at least partly new data are intended to be programmed, one memory block being used as a safeguard memory block (7) and the other memory block being used as a scratchpad memory block (8), in that, in a first step, the scratchpad memory block (8) and the safeguard memory block (7) are erased, in that, in a second step, the content of the data memory block (3) is copied into the safeguard memory block (7), in that, in a third step, the data memory block (3) is erased, in that, in a fourth step, the new data are programmed into the data memory block (3), in that, in a fifth step, the addresses under which the new data have been programmed into the data memory block (3) are programmed into the scratchpad memory block (8), and in that, in a sixth step, the data are copied back from the safeguard memory block (7) into the data memory block (3), only those addresses of the data memory block (3) which are not identified as being occupied by new data in accordance with the entries in the scratchpad memory block (8) being overwritten with the corresponding data from the safeguard memory block (7).

2. Method according to Claim 1, characterized in that, as a seventh step, a checksum is calculated for the data memory block (3), and in that, proceeding from the result of the checksum, a data word (PSA) which supplements the calculated checksum to form a predetermined checksum result, in particular 0, is programmed into a memory location of the data memory block (3) that is left free for this purpose.

3. Method according to Claim 1 or 2, characterized in that a respective memory block in the electrically erasable, non-volatile memory (12) is used as safeguard memory block (7) and as scratchpad memory block (8).

4. Method according to Claim 1 or 2, characterized in that a respective memory block in a volatile memory (13) of the electronic computing unit (10) is used as safeguard memory block (7) and/or as scratchpad memory block (8).

5. Method according to one of the preceding claims, characterized in that the new data are transmitted from an external programming unit (18) to the electronic computing unit (10) via a serial data transmission line (16).

6. Control unit for carrying out the method according to Claim 1, in particular motor vehicle control unit, having a microcomputer, having an electrically erasable, non-volatile memory which is divided into a number of memory blocks and can be erased in blocks, having a serial interface for communication with an external electronic unit, having means for programming the electrically erasable, non-volatile memory, characterized in that a safeguard memory block (7), to which the data of a data memory block (3) to be programmed can be written, is provided as means for programming the electrically erasable, non-volatile memory (12), and in that a scratchpad memory block (8) is additionally provided, to which can be written information items, in particular marker data words, which specify the addresses of the data memory block (3) to be programmed under which reprogramming is intended to take place or has taken place.

7. Control unit according to Claim 6, characterized in that the safeguard memory block (7) and/or scratchpad memory block (8) is part of the electrically erasable, non-volatile memory (12).

8. Control unit according to Claim 6, characterized in that the safeguard memory block (7) and/or scratchpad memory block (8) is part of a volatile memory (13).

9. Control unit according to one of Claims 6 to 8, characterized in that the electrically erasable, non-volatile memory (12) is a flash EPROM.

## Revendications

1. Procédé de programmation d'une mémoire non volatile, effaçable électriquement dans un calculateur électronique, notamment un appareil de commande de véhicule automobile, cette mémoire non volatile effaçable électriquement étant subdivisée en un certain nombre de blocs mémoire et l'effacement de la mémoire non volatile effaçable électriquement n'étant possible que par blocs,
caractérisé en ce que

- pour la programmation, il y a au moins deux blocs de mémoire (7, 8) en dehors d'un bloc d'enregistrement de données dans lequel on programme au moins en partie de nouvelles données, l'un des blocs mémoire étant utilisé comme bloc mémoire de sécurité (7) et l'autre bloc mémoire, comme bloc mémoire bloc-notes (8),
- au cours d'une première étape, on efface le bloc mémoire bloc-notes (8) et le bloc mémoire de sécurité (7),
- dans une seconde étape, on copie le contenu du bloc mémoire de données (3) dans le bloc mémoire de sécurité (7),
- dans une troisième étape, on efface le bloc mémoire de données (3),
- dans une quatrième étape, on programme dans le bloc mémoire de données (3), les nouvelles données,
- dans une cinquième étape, on programme dans le bloc mémoire bloc-notes (8) à quelles adresses les nouvelles données seront programmées dans le bloc mémoire (3), et
- dans une sixième étape, on copie en retour les données du bloc mémoire de sécurité (7) dans le bloc mémoire de données (3), en ne surscrivant que celles des adresses du bloc mémoire de données (3) avec les données correspondantes du bloc mémoire de sécurité (7) qui, en fonction des entrées dans le bloc mémoire bloc-notes (8), ne peuvent être reconnues comme occupées avec les nouvelles données.

2. Procédé selon la revendication 1,
caractérisé en ce que

- selon une septième étape, on calcule une somme de contrôle pour le bloc mémoire de données (3), et
- partant du résultat de la somme de contrôle, on programme dans une cellule de mémoire laissée libre à cet effet dans le bloc mémoire de données (3), un mot de données (PSA) qui complète la somme de contrôle calculée pour avoir un résultat prédéfini de somme de contrôle, notamment 0.

3. Procédé selon l'une quelconque des revendications 1 ou 2,
caractérisé en ce que
comme bloc mémoire de sécurité (7) et comme bloc mémoire bloc-notes (8), on utilise chaque fois un bloc mémoire de la mémoire non volatile, effaçable électriquement (12).

4. Procédé selon l'une quelconque des revendications 1 ou 2,
caractérisé en ce que
comme bloc mémoire de sécurité (7) et/ou comme bloc mémoire bloc-notes (8), on utilise chaque fois un bloc mémoire dans une mémoire volatile (13) de l'appareil de calcul électronique (10).

5. Procédé selon l'une quelconque des revendications précédentes,
caractérisé en ce qu'
on transfère les nouvelles données à un appareil de programmation externe (18) dans le calculateur électronique (10) par une ligne de transmission série, de données(16).

6. Appareil de commande pour la mise en oeuvre du procédé selon la revendication 1, notamment pour des appareils de commande de véhicules automobiles comprenant :

- un microcalculateur,
- une mémoire non volatile, effaçable électriquement, subdivisée en un certain nombre de blocs mémoire et qui peut s'effacer par blocs,
- une interface série pour communiquer avec un appareil électronique externe,
- des moyens de programmation de la mémoire non volatile effaçable électriquement,

caractérisé en ce que

- les moyens de programmation de la mémoire non volatile effaçable électriquement (12) sont constitués par un bloc mémoire de sécurité (7), dans lequel on inscrit les données d'un bloc mémoire de données (3) à programmer, et
- en plus, il est prévu un bloc mémoire bloc-notes (8) dans lequel on inscrit des informations notamment les mots de données caractéristiques indiquant les adresses du bloc mémoire de données à programmer (3), auxquelles une nouvelle programmation doit être ou a été faite.

7. Appareil de commande selon la revendication 6,
caractérisé en ce que le bloc mémoire de sécurité (7) et/ou le bloc mémoire bloc-notes (8) font partie de la mémoire non volatile, effaçable électriquement (12).

8. Appareil selon la revendication 6,
caractérisé en ce que
le bloc mémoire de sécurité (7) et/ou le bloc mémoire bloc-notes (8) font partie d'une mémoire volatile (13).

9. Appareil de commande selon l'une quelconque des revendications 6 à 8, caractérisé en ce que la mémoire non volatile, effaçable électriquement (12) est une mémoire Flash-EPROM.

# Fig. 1

# Fig. 4

| | |
|---|---|
| 00111101 | }PSA |
| 00110100 | |
| 10001000 | |
| 11000001 | }D |
| 00000110 | |

EP 0 715 313 B1

# Fig. 2a b

**Start** — 30     **Start** — 40

31 — Programmierfreigabe anfordern  ↔  41 — Paßwort abfragen

32 — Paßwort senden  ←  42 — Paßwort ok ? — n — 43 — Ende

j

33 — Einzelbytes für zu programmierenden Speicherblock X angeben  →  44 — Speicherblock 7 und 8 löschen

45 — Speicherblock X in Speicherblock 7 kopieren

46 — Speicherblock X löschen

47 — Einzelbytes in Speicher- block X programmieren

48 — Adressen von Einzelbytes in Speicherblock X in Speicherblock 8 programmieren

49 — Daten von Speicherblock 7 in Speicherblock 3 zurückkopieren

50 — Prüfsumme von Speicherblock X berechnen und abgleichen

34 ┄┄┄  ↔  51 — weiteren Speicherblock programmieren ? — j

35 — Ende     43 — Ende

10

Fig. 3 a) b) c) d) e) f) g)

$1C000
$18000
$14000
$10000
$0C000
$08000
$04000
$0000

EP 0 715 313 B1